# EUROPEAN PATENT SPECIFICATION

(11) **EP 0 933 815 B1**
(45) Date of publication and mention of the grant of the patent: **09.11.2005**
(21) Application number: 99870014.0
(22) Date of filing: 27.01.1999
(51) Int. Cl.: H01L 23/532

(54) **A metallization structure on a fluorine-containing dielectric and a method for fabrication thereof**
Metallisierungsstruktur auf einem fluorhaltigen Dielektrikum und Herstellungsverfahren dafür
Structure de métallisation sur un diélectrique contenant du fluor et son procédé de fabrication

(30) Priority: 28.01.1998 US 72895 P; 23.07.1998 EP 98870163
(43) Date of publication of application: 04.08.1999
(73) Proprietor: INTERUNIVERSITAIR MICROELEKTRONICA CENTRUM VZW, 3001 Leuven (BE)
(72) Inventor: Maex, Karen, 3020 Herent (BE); Rodionovich Baklanov, Mikhail, 3000 Leuven (BE); Vanhaelemeersch, Serge, 3001 Leuven (BE)
(74) Representative: Van Malderen, Joelle

(56) References cited:
- EP-A- 0 849 796
- US-A- 5 661 334
- PATENT ABSTRACTS OF JAPAN vol. 098, no. 002, 30 January 1998 -& JP 09 275138 A (TOSHIBA CORP), 21 October 1997 -& US 5 850 102 A (TADASHI MATSUNO) 15 December 1998
- LI WEIDAN ET AL: "Thermal stability study of the interconnect system with fluorinated silicate glass as IMD layers" 1997 , PROCEEDINGS OF THE 1997 MRS SPRING MEETING;SAN FRANCISCO, CA, USA APR 1-4 1997 , MATER RES SOC SYMP PROC;MATERIALS RESEARCH SOCIETY SYMPOSIUM PROCEEDINGS; LOW-DIELECTRIC CONSTANT MATERIALS III 1997 MRS, WARRENDALE, PA, USA, PAGE(S) 261 - 266 XP002102302 * page 263; figure 6 *

## Description

### FIELD OF THE INVENTION

The present invention is related to a new metallization structure being part of a structure used to interconnect electronic components or devices. Such components or devices can be part of an integrated circuit. Particularly, a multi-level Cu-containing metallization structure is disclosed based on fluorine-containing dielectrics.

### BACKGROUND OF THE INVENTION

The ongoing miniaturization in integrated circuits with increased complexity and multilevel metal layers and the focus on increasing speed of these circuits demand for low permittivity materials, particularly for use as intermetal dielectric layers. Conventionally, metal interconnects, mostly aluminum layers, with silicon dioxide as intermetal dielectric are used, but this conventional solution will not be able to meet the stringent specifications resulting from the above mentioned trends. Therefore, to avoid that the larger portion of the total circuit delay is caused by the resistance and capacitance of the interconnect system, one has to reduce the permittivity of the dielectric used. This is stated in numerous publications, e.g. in Table 1 of R.K. Laxman, "Low ε dielectric: CVD Fluorinated Silicon Dioxides", Semiconductor International, May 1995, pp. 71-74. Therefore miniaturization has lead to an intensified search for new low K materials. A low ε material, a low K material and a material with a low permittivity are all alternative expressions for a material with a low dielectric constant, at least for the purposes of this disclosure. The most desirable material should have a low K value, low mechanical stress, high thermal stability and low moisture absorption. Furthermore, the desired material should be selected based on the compatibility with state-of-the-art semiconductor processing steps and tools.

Part of the search for new low K materials was directed to changing the properties of silicon dioxide as deposited. Deposited silicon dioxide is the most widely used intermetal dielectric material having a K value of about 3.9. Several publications have indicated that the K value of silicon dioxide films can be reduced by introducing increasing amounts of fluorine in said films. Fluorine is the most electronegative and the least polarizable element on the periodic table. Incorporation of fluorine reduces the number of polarizable Si-OH bonds and also influences the silicon oxide such that it has a less polarizable geometry to thereby lowering the K value of the fluorinated silicon oxide films. A wide variety of processes to deposit fluorinated silicon oxide films are known like e.g. a Plasma Enhanced Chemical Vapour Deposition (PECVD) process as in the United States patent US5641581. Using these processes K values in the range between 3 and 3.5 are reported dependent on the amount of fluorine atoms incorporated, i.e. an increasing amount of fluorine leads to a decrease of the K value.

Besides the focus on changing the properties of silicon oxide, there is an ongoing search for new low K materials. Among these new materials are the organic spin-on materials, having a K value in the range from 2.5 to 3, and the inorganic low-K materials as e.g. xerogels having a K value typically lower than 1.5. Many of these new low-K materials comprise fluorine. The organic materials are of particular interest because they feature simplified processing, excellent gap-fill and planarization. Furthermore the K-value of organic materials, which comprise Phenyl groups, can be additionally lowered by plasma fluorination as e.g. in H. Kudo et al., Mat. Res. Symp. Proc., Vol. 381, pp. 105-110, 1985. By doing so the K-values can be lowered yielding a range from 2 to 2.5 instead of from 2.5 to 3.

In summary, it is clear that fluorine-containing dielectrics have in general a lower K-value than there unfluorinated counterparts. This holds both for polymer like and ceramic like dielectrics. Therefore fluorine-containing dielectrics are of particular interest in order to avoid that the larger portion of the total circuit delay is caused by the capacitance of the interconnect system. Despite all these advantages fluorine-containing dielectrics are not compatible with current metallization structures using metallization materials such as Ti, or Ta, or W, or the nitrides of each of the aforementioned materials, or Cu, or Al. This is due to the fact that the incorporation of fluorine has been shown to be detrimental for the aforementioned metallization materials.

Document JP-A-09 275 138 discloses as prior art a metallization structure comprising: a conductive pattern,
a fluorine-containing dielectric; and
a barrier layer of TiN comprising a part which is positioned between said fluorine-containing dielectric and said conductive pattern. The fluorine in the dielectric layer reacts with the Ti in the barrier layer and thus deteriorates the quality of the TiN barrier layer.

This document suggests as a solution to this problem a layer of silicon oxide or silicon nitride between the dielectric layer and the barrier layer, which according to one embodiment may comprise Ni, instead of Ti.

### AIMS OF THE INVENTION

It is an aim of the present invention to provide a metallization structure which is compatible with fluorine-containing dielectrics. Therefore, a layer has to be provided which is at least conductive and substantially impermeable for fluorine, i.e. forms a diffusion barrier for fluorine. Preferably, this layer has a low contact resistance to a silicon layer or silicon substrate. In case this metallization structure comprises Cu, a layer has to be provided which is substantially impermeable for Cu.

It is a further aim of the invention to provide a metallization structure being compatible with fluorine-containing dielectrics and comprising a layer which is at least conductive, impermeable for fluorine and impermeable for Cu. Even more preferably, this layer has a low contact resistance to a silicon layer or silicon substrate.

### SUMMARY OF THE INVENTION

In an aspect of the invention a metallization structure is disclosed comprising a barrier layer, said barrier layer being formed on the exposed parts, i.e. the uncovered parts, of a fluorine-containing dielectric. This barrier layer should adhere well on said fluorine-containing dielectric. This barrier layer should also neither corrode nor reveal a deterioration of its characteristics by the exposure to a fluorine. Furthermore, this barrier layer should also form a diffusion barrier for fluorine, by forming stable non-volatile fluorides, in order to inhibit the corrosion of other parts of the metallization structure. According to this aspect of the invention, a metallization structure is disclosed as described in claim 1.

In an embodiment of the invention, a metallization structure is disclosed comprising a barrier layer of a near noble metal which is at least highly impermeable for fluorine and preferably impermeable for Cu. Preferably the near noble metal Co is use which forms a barrier layer which is both substantially impermeable for fluorine and for Cu. Co is much less reactive than the refractory metals. Co adheres well on fluorine-containing silicon oxide based materials as well as on fluorine-containing organic polymers. Moreover, in contact with a silicon substrate Co can form a silicide-cobalt having a low resistivity and a low contact resistance to a silicon substrate. For the purposes of this disclosure, a silicide-cobalt is defined as CoₓSi_{y}, x and y being positive numbers. Moreover, the fluorides of Co are stable and non-volatile, i.e. contrary to e.g. Ti. Furthermore, it has been revealed that Co reacts readily with fluorine thereby forming an in-situ cobalt-fluoride layer, i.e. a layer of CoₓF_{y}, x and y being positive numbers. The growth of this cobalt-fluoride layer is self limiting resulting in a maximum thickness of the layer of about 5 nm. The thickness of this layer is typically 3 to 4 nm. Consequently, contrary to e.g. Ti which is permeable for fluorine, by the reaction of Co or another near noble metal selected from the group consisting of Ni, Pd and (Pt, with a fluorine-containing dielectric a layer of a fluoride of this near noble metal is formed. This layer inhibits the out-diffusion of fluorine from said fluorine-containing dielectric and thereby avoids the exposure of other parts of the metallization structure to fluorine.

In another embodiment of the invention, a metallization structure is disclosed where the conductive pattern is composed of at least one metal selected from a group comprising Al, Cu, an Al-alloy and a Cu-alloy. Particularly, a Cu-containing metals is selected. This metallization structure can further comprise a barrier layer, impermeable for copper, being positioned between said conductive pattern and said contact barrier layer. Preferably, this barrier layer is a Ta layer or a compound thereof.

In another embodiment of the invention, a metallization structure is disclosed, further comprising a second part of said barrier layer of said conductive material, being positioned between silicon layer and said conductive pattern and wherein said second part is in contact with said silicon layer. Particularly, the silicon layer can be at least a part of a silicon wafer. This second part of said barrier layer comprises a first sub-layer of said conductive material, e.g. Co or another near noble material, and a second sub-layer of a silicide of said conductive material, e.g. a silicide-cobalt, said second sub-layer contacting said silicon layer. This second sub-layer provides a low ohmic contact to the exposed parts of the silicon layer.

In another aspect of the invention, a method for fabricating a metallization structure on a substrate is disclosed, as described in claim 12.

In a further embodiment of the present invention the reaction between the layer of the conductive material, i.e. the barrier layer, and the fluorine-containing dielectric is stimulated by heating the substrate. Particularly, this heating can be performed at a temperature between room temperature and 500 degrees C, or between 50 degrees C and 500 degrees C, or between 50 degrees C and 300 degrees C.

In another embodiment of the invention, a method is disclosed to fabricate a metallization structure, wherein prior to the formation of the conductive pattern, preferably composed of Cu or a Cu-alloy, an additional layer, impermeable for Cu, is deposited on the barrier layer of the near noble metal. Preferably, this additional layer is a layer comprising Ta or a compound thereof.

### BRIEF DESCRIPTION OF THE DRAWINGS

Figure 1 depicts a schematic process-flow used to fabricate a particular metallization structure, i.e. a dual-damascene structure, according to an embodiment of the invention.

Figure 2 depicts XPS (X-ray Photo-electron Spectroscopy) spectra of some samples which are configured as follows:
A Co layer with a thickness of 10 nm is deposited by means of a physical vapor deposition technique on an in-situ fluorinated FLARE™ II layer. The thickness of the FLARETM IIlayer is 600nm. Prior to the Co deposition the FLARE™ II layer is in-situ fluorinated by exposure in a chamber of a plasma tool to an ambient comprising NF₃. The pressure in the chamber was 1.3 Torr will the ambient temperature was 80 degrees C.
The FLARE™ II layer was deposited on a silicon wafer with a silicon dioxide layer thereon.
After the Co deposition, some samples (21) were heated during 10 minutes at 350 degrees C, while some samples (20) were not subjected to a heat treatment. Next, samples are given for XPS analysis. The analysis is performed at the interface layer between the Co and the fluorinated FLARE™ II layer.

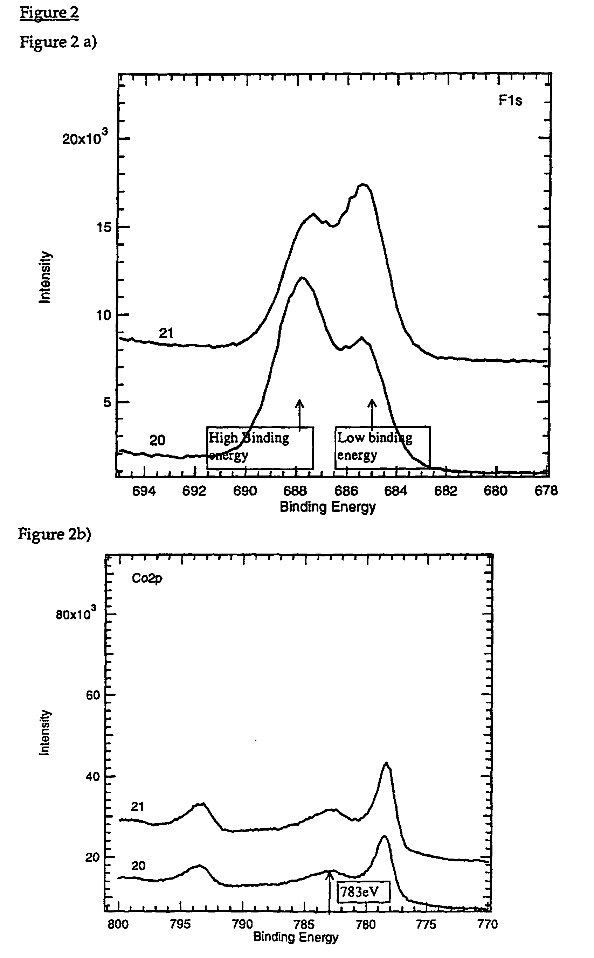

Figure 2a) depicts the F *1s* peak.

Figure 2b) depicts the Co *2p* peak.

Remark that the intensity scale in both pictures may only be used to determine relative intensities.

Both samples have a very intense F peak. In addition, the Co*2p* peak of both samples has a clear high binding energy structure (~783 eV) which can be related to the low binding energy peak of the F*1s* peak and attributed to a fluoride of Co. The high binding energy peak of the F*1s* peak is attributed to C-F bounds, where the C originates from the FLARE™ II layer.

When comparing the spectra of the samples with (21) or without heat treatment (20), from the F*1s* spectra, it can be concluded that the fluoride intensities are significantly higher than the C-F intensities. This indicates a stronger reaction due to the heat treatment.

### DETAILED DESCRIPTION OF THE INVENTION

In relation to the appended drawings the present invention is described in detail in the sequel.

The introduction of fluorine-containing dielectrics in modem and future semiconductor processes requests a metallization structure which is compatible with said fluorine-containing dielectrics. This fluorine-containing dielectric can be a polymer like or ceramic like dielectric, e.g. a fluorinated silicon oxide. Alternatively this fluorine-containing dielectric can also be a dielectric where the fluorine is introduced only after the deposition, for instance by plasma fluorination. This holds especially for organic polymers comprising unsaturated carbon bonds such as phenyl groups. Examples of organic polymers comprising phenyl groups are the benzocyclobutarenes, i.e. benzocyclobutene (BCB) commercially available as Cyclotene 5021™, poly arylene ether, i.e FLARE™ II, aromatic hydrocarbon, i.e. SILK™, polyimides. An advantage of introducing fluorine after the deposition is that this fluorination can be performed locally. This fluorine-containing dielectric is formed on a substrate. The substrate can be a partly processed or a pristine wafer or slice of a semi-conductive material, like Si or Ga As or Ge, or an insulating material, e.g. a glass slice, or a conductive material. Said substrate can comprise a patterned conductive layer. Particularly, in case said substrate is a partly processed wafer or slice; at least a part of the active and/or passive devices can already be formed and/or at least a part of the structures interconnecting these devices can be formed.

In order to be compatible with a fluorine-containing dielectric a metallization structure has to be configured comprising a barrier layer, said barrier layer being formed on the exposed parts, i.e. the uncovered parts, of a fluorine-containing dielectric. This barrier layer should adhere well on said fluorine-containing dielectric. This barrier layer should also neither corrode nor reveal a deterioration of its characteristics by the exposure to fluorine. Furthermore, this barrier layer also has to form at least a diffusion barrier for fluorine in order to inhibit the corrosion of other parts of the metallization structure. Preferably this barrier layer should also form a diffusion barrier layer for Cu.

In an embodiment of the invention, a metallization structure is disclosed comprising a barrier layer, said layer comprising a near noble metal. Preferably the near noble metal Co is used. Co is much less reactive than the refractory metals. Co adheres well on fluorine-containing silicon oxide based materials and fluorine-containing polymers. The fluorides of Co are stable and non-volatile, i.e. contrary to e.g. Ti. A further advantage of Co is that it can be selectively deposited using an electroless plating technique. It has been revealed (see also figure 2) that Co reacts readily with fluorine thereby forming an in-situ cobalt-fluoride layer, i.e. a layer of CoₓF_{y}, x and y being positive numbers. The growth of this cobalt-fluoride layer is a self limiting reaction yielding a maximum thickness of about 5 nm. This reaction can occur spontaneously (20) dependent on the deposition technique used for the deposition of Co or stimulated by applying a heat treatment (21). Consequently, contrary to e.g. Ti which is permeable for fluorine, by the reaction of Co with a fluorine-containing dielectric a diffusion barrier is formed inhibiting the out-diffusion of fluorine from said fluorine-containing dielectric and thereby avoiding exposure of other parts of the metallization structure to fluorine. Furthermore, in contact with a silicon substrate Co can form a silicide-cobalt having a low resistivity and a low contact resistance to a silicon substrate. For the purposes of this disclosure, a silicide-cobalt is defined as CoₓSi_{y}, x and y being positive numbers.

Besides a barrier layer, preferably comprising a near noble metal, particularly Co, said metallization structure can further comprise a conductive pattern, for instance a conductive line or a set of conductive lines. Preferably, said conductive pattern is composed of Cu or a Cu alloy. Cu is an interesting material due to its low resistivity. Furthermore, from the binary phase diagrams, it is known that Co does not form intermetallic compounds with Cu. Using Cu can also have some disadvantages. A first possible disadvantage is that Cu easily corrodes when being exposed to fluorine. However, this corrosion is inhibited by the in-situ formed barrier layer of a fluoride of cobalt which inhibits the out-diffusion of fluorine. A second possible disadvantage can be the migration of Cu in the surrounding materials resulting in a deterioration of the electrical and mechanical characteristics of these materials. However the in-situ formed barrier layer of cobalt-fluoride is also a diffusion barrier for Cu. Therefore said barrier layer can be used to encapsulate the Cu.

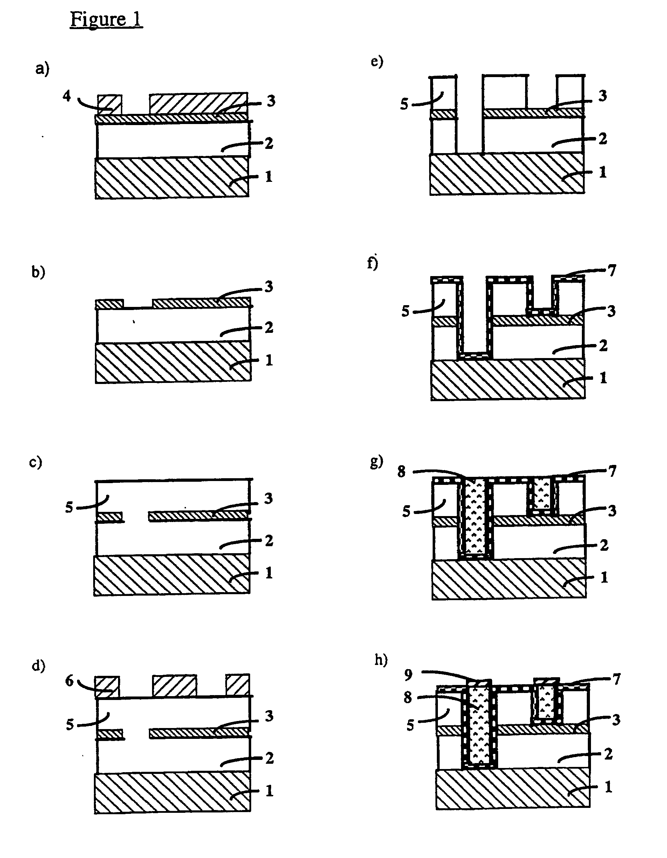

In another embodiment of the invention, as an example, a metallization structure and a method for fabricating this particular metallization structure, i.e. a dual damascene structure, is proposed (see fig. 1). It should be clear however that the invention is not limited to this particular structure but the present invention can be applied for any metallization structure comprising a fluorine-containing dielectric. Metallization structures are structures used to connect and interconnect active and/or passive devices. These structures can comprise multiple metal levels which are, dependent on the desired connection pattern, either separated one from another by means of interlevel or intralevel fluorine-containing dielectric layers or connected one to the other by means of a conductive connection through the fluorine-containing dielectric layer(s). These fluorine-containing layers can comprise openings such as via holes, trenches or contact openings.

### Example:

On a flattened substrate, i.e. a silicon wafer (1), a first fluorine-containing dielectric layer (2) is formed. This fluorine-containing dielectric can be a polymer like or ceramic like dielectric, e.g. a fluorinated silicon oxide. Alternatively this fluorine-containing dielectric can also be a dielectric where the fluorine is introduced only after the deposition, for instance by plasma fluorination. This holds for organic polymers comprising Phenyl groups. Examples of such polymers are the benzocyclobutarenes, i.e. benzocyclobutene (BCB) commercially available as Cyclotene 5021™, poly arylene ether, i.e FLARE™ II, aromatic hydrocarbon, i.e. SILK™, polyimides. An advantage of introducing fluorine after the deposition is that this fluorination can be performed locally.

A hard mask layer (3), e.g. a silicon nitride layer, is formed on the first fluorine-containing dielectric layer. A hard mask layer is defined as a layer which can be etched selective to the underlying dielectric layer. A lithographic resist layer (4) is deposited and patterned (step a)). The hard mask layer is patterned (step b)) with a RIE (reactive ion etch) step using the patterned lithographic developed resist (4) as a mask thereby creating at least one hole where the surface of the first fluorine-containing dielectric layer is exposed. After the RIE step the resist left-over is removed.

A second fluorine-containing dielectric layer (5) is formed (step c)) over the patterned hard mask layer and a resist layer (6) is formed on this second fluorine-containing dielectric layer. The resist layer is patterned (step d)) and the second fluorine-containing dielectric layer is etched using the patterned resist layer as a mask which can result in the formation of a trench. The hard mask layer functions as an etch stop layer thereby preventing the extension from the trench in the first fluorine-containing dielectric layer (step e)). The first dielectric layer is then etched using the patterned hard mask layer as a mask to form a contact to the substrate, i.e. exposing the surface of the substrate (step e)). The etching of the first and second dielectric layer can be performed using a single etch step or two etch steps. The patterned resist layer is removed.

A thin layer (7) of a near noble metal, preferably Co, is formed (step f))over the exposed parts of the hard mask layer and the first and second fluorine-containing dielectric layer. By the reaction of Co and F, said F being supplied by said dielectric layer, a cobalt-fluoride layer, i.e. a layer of CoₓF_{y}, x and y being positive numbers, is formed at the interface between said dielectric layer and said Co layer to thereby form a diffusion barrier for said fluorine. This reaction can be stimulated by a heating step. However the growth of the cobalt-fluoride layer is a self-limiting process yielding a maximum thickness of 5nm. At the contact area to the substrate, i.e. at the interface between the substrate and the Co layer, a fluorinated cobaltsilicide is formed with a low contact resistance. So as explained before, in fact a contact barrier layer is formed.

A conductive layer (8), preferably a Cu layer, is deposited. The Cu layer fills the contact in the first and second dielectric layer and the trench in the second dielectric layer.

The conductive layer is planarized (step g)) to electrically isolate the trenches or contacts one from another. This planarization can be performed using chemical mechanical polishing (CMP). The Cu is almost completely encapsulated by the Co inhibiting the out-diffusion of the Cu, only at the topside the Cu is still uncovered.

In order to completely encapsulate the Cu, a second layer of Co (9) can be deposited selectively (step h)) on the Cu. Subsequent deposition of a third fluorine-containing dielectric (or exposure to fluorine) will lead to a similar formation of a cobalt-fluoride layer on said second Co layer and completely encapsulate the Cu.

Co is typically a metal that allows deposition by electroless plating. If an adequate activation is performed, Cu as well as Co can be deposited using plating deposition. Consequently the complete metallization sequence as described in the example but not limited hereto can be carried out using plating deposition without the need for physical vapour deposition (PVD).

In an embodiment of the invention, a method for fabricating a metallization structure is disclosed comprising the steps of:
depositing a first thin Co layer, or a layer of another near noble metal selected from the group consisting of Ni, Pd and Pt, on a first fluorine-containing dielectric layer, said deposition leading to the reaction of Co and F, said F being supplied by said first dielectric layer, to thereby grow a cobalt-fluoride layer at the interface between said first dielectric layer and said first Co layer;
depositing Cu, or another metal like e.g. Al or an Al alloy, on said first Co layer;
depositing a second Co layer selectively on the Cu
exposing said second Co layer to fluorine, e.g. by depositing a second fluorine-containing dielectric on said second Co layer, leading to the formation of a cobalt-fluoride layer on said Co.

In a further embodiment of the invention, a metallization structure is fabricated by first depositing a Co layer, with a thickness typically between 80nm and 200nm, or a layer of another near noble metal selected from the group consisting of Ni, Pd and Pt, on a fluorine-containing dielectric layer. Preferably this fluorine-containing dielectric comprises at least one opening as e.g. a via hole or a trench. This deposition can e.g. be done using a physical vapor deposition technique and such that a barrier layer is formed at least in these openings. This deposition leads to the reaction of Co and F, said F being supplied by said dielectric layer, to thereby grow a layer of a fluoride of said Co at the interface between said dielectric layer and said first Co layer. This reaction can be stimulated by applying a heating step. Anyhow, as this reaction is self-limiting the thickness of the layer of said fluoride is typically between 3 and 5 nm. This fluoride layer forms a diffusion barrier layer which is both impermeable for fluorine and Cu. Particularly, thereafter the Co layer on this fluoride layer can be removed selectively to the underlying fluoride layer by an electrochemical etch. Thereafter a Cu-containing metal can be deposited on the fluoride layer, preferably by means of electroplating, to thereby at least completely fill these openings.

## Claims

1. A metallization structure comprising:
- a conductive pattern (8);
- a fluorine-containing dielectric (5); and
- a conductive fluorine diffusion barrier layer (4) comprising at least a first part, being positioned between said fluorine-containing dielectric and said conductive pattern, said first part consisting of a first sub-layer made of a conductive material, and a second sub-layer made of a fluoride of said conductive material and being adjacent to said fluorine-containing dielectric, said conductive material being selected from the group consisting of Co, Ni, Pt and Pd.

2. The structure as recited in claim 1, wherein said conductive barrier layer completely encapsulates said fluorine-containing dielectric.

3. The structure as recited in claim 1, wherein said conductive barrier layer completely encapsulates said conductive pattern.

4. The structure as recited in any of the claims 1 to 3, where said conductive pattern is composed of at least one metal selected from the group consisting of Al, Cu, an Al-alloy and a Cu-alloy.

5. The structure as recited in any of the claims 1 to 4, wherein said fluorine-containing dielectric comprises at least one opening.

6. The structure as recited in claim 5, wherein said opening is a via hole or a trench.

7. The structure as recited in any of the claims 1 to 6, where said conductive pattern is composed of Cu or a Cu-alloy.

8. The structure as recited in claim 7, further comprising a Cu-barrier layer, being impermeable for copper and positioned between said conductive pattern and said conductive barrier layer.

9. The structure as recited in claim 8, where said Cu-barrier layer is a Ta layer or a compound thereof.

10. The structure as recited in any of the claims 1 to 9, wherein said conductive barrier layer further comprises a second part, being positioned between a silicon layer and said conductive pattern, said second part consisting of a third sub-layer of said conductive material and a fourth sub-layer of a silicide of said conductive material, said fourth sub-layer contacting said silicon layer.

11. The structure as recited in claim 10, where said silicon layer is at least a part of a silicon wafer.

12. A method for fabricating a metallization structure as described in any one of claims 1 to 11 on a substrate comprising the steps of:
- depositing a layer of a conductive material being selected from the group consisting of Co, Ni, Pt and Pd, on at least one exposed surface of a fluorine-containing dielectric formed on said substrate;
- allowing the reaction between said layer of said conductive material and said fluorine-containing dielectric to thereby form a layer of a fluoride of said conductive material at the interface between said layer of said conductive material and said fluorine-containing dielectric in order to create the conductive fluorine diffusion barrier layer; and
- depositing at least one metal on said layer of said conductive material in order to create the conductive pattern.

13. The method as recited in claim 12, wherein said metal is selected from the group consisting of Al, Cu, an Al-alloy and a Cu-alloy.

14. The method as recited in any of the claims 12 to 13, wherein prior to the deposition of said metal a Cu-barrier layer is formed at least on said layer of said conductive material.

15. The method as recited in claim 14, wherein said Cu-barrier layer is a layer comprising Ta or a compound thereof.

16. The method as recited in any of the claims 12 to 15, wherein said reaction is stimulated by heating said substrate.

17. The method as recited in claim 16, wherein said heating is performed at a temperature in the range from 50 degrees C to 400 degrees C.

## Patentansprüche

1. Metallisierungsstruktur, welche aufweist:
- ein leitfähiges Muster (8) ;
- ein Fluor enthaltendes Dielektrikum (5); und
- eine leitfähige Fluordiffusionsbarrierenschicht (4), welche mindestens einen ersten Teil umfasst, welcher zwischen dem besagten Fluor enthaltenden Dielektrikum und dem besagten leitfähigen Muster angeordnet ist, wobei dieser besagte erste Teil aus einer ersten Unterschicht besteht, welche aus einem leitfähigen Material hergestellt ist, und aus einer zweiten Unterschicht besteht, welche aus einem Fluorid aus dem besagten leitfähigen Material hergestellt ist und welche an das besagte Fluor enthaltende Dielektrikum angrenzt, wobei das besagte leitfähige Material ausgewählt ist aus der Gruppe bestehend aus Co, Ni, Pt und Pd.

2. Struktur gemäß Anspruch 1, bei welcher die besagte leitfähige Barrierenschicht das besagte Fluor enthaltende Dielektrikum vollständig einkapselt.

3. Struktur gemäß Anspruch 1, bei welcher die besagte leitfähige Barrierenschicht das besagte leitfähige Muster vollständig einkapselt.

4. Struktur gemäß irgendeinem der Ansprüche 1 bis 3, bei welcher das besagte leitfähige Muster zusammengesetzt ist aus mindestens einem Metall, das ausgewählt ist aus der Gruppe bestehend aus Al, Cu, einer Al-Legierung und einer Cu-Legierung.

5. Struktur gemäß irgendeinem der Ansprüche 1 bis 4, bei welcher das besagte Fluor enthaltende Dielektrikum mindestens eine Öffnung aufweist.

6. Struktur gemäß Anspruch 5, bei welcher die besagte Öffnung ein Durchgangsloch oder einen Graben darstellt.

7. Struktur gemäß irgendeinem der Ansprüche 1 bis 6, bei welcher das besagte leitfähige Muster zusammengesetzt ist aus Cu oder einer Cu-Legierung.

8. Struktur gemäß Anspruch 7, welche weiterhin eine Cu-Barrierenschicht enthält, welche für Kupfer undurchlässig ist und welche zwischen dem besagten leitfähigen Muster und der besagten leitfähigen Barrierenschicht angeordnet ist.

9. Struktur gemäß Anspruch 8, bei welcher die besagte Cu-Barrierenschicht aus einer Schicht aus Ta oder einer Verbindung desselben besteht.

10. Struktur gemäß irgendeinem der Ansprüche 1 bis 9, bei welcher die besagte leitfähige Barrierenschicht weiterhin einen zweiten Teil aufweist, welcher zwischen einer Siliziumschicht und dem besagten leitfähigen Muster angeordnet ist, wobei der besagte zweite Teil aus einer dritten Unterschicht aus dem besagten leitfähigen Material und aus einer vierten Unterschicht aus einem Silicid des besagten leitfähigen Materials besteht, wobei die besagte vierte Unterschicht sich im Kontakt mit der besagten Siliziumschicht befindet.

11. Struktur gemäß Anspruch 10, bei welcher die besagte Siliziumschicht mindestens einen Teil eines Siliziumwafers darstellt.

12. Verfahren zur Herstellung einer Metallisierungsstruktur, so wie sie in irgendeinem der Ansprüche 1 bis 11 beschrieben worden ist, auf einem Substrat; Verfahren das die nachfolgenden Verfahrensschritte aufweist:
- ein Abscheiden einer Schicht eines leitfähigen Materials, welches ausgewählt ist aus der Gruppe bestehend aus Co, Ni, Pt und Pd, auf mindestens einer ausgesetzten Oberfläche eines Fluor enthaltenden Dielektrikums, welches auf dem besagten Substrat ausgebildet worden ist;
- ein Ermöglichen der Reaktion zwischen der besagten Schicht des besagten leitfähigen Materials und des besagten Fluor enthaltenden Dielektrikums, um **dadurch** eine Schicht eines Fluorids des besagten leitfähigen Materials an der Grenzfläche zwischen der besagten Schicht des besagten leitfähigen Materials und dem besagten Fluor enthaltenden Dielektrikum zu bilden, um die leitfähige Fluordiffusionsbarrierenschicht zu erzeugen; und
- ein Abscheiden von mindestens einem Metall auf der besagten Schicht des besagten leitfähigen Materials, um das leitfähige Muster zu erzeugen.

13. Verfahren gemäß Anspruch 12, bei welchem das besagte Metall ausgewählt ist aus der Gruppe bestehend aus Al, Cu, einer Al-Legierung und einer Cu-Legierung.

14. Verfahren gemäß irgendeinem der Ansprüche 12 bis 13, bei welchem vorab zu dem Abscheiden des besagten Metalls eine Cu-Barrierenschicht mindestens auf der besagten Schicht des besagten leitfähigen Materials gebildet wird.

15. Verfahren gemäß Anspruch 14, bei welchem die besagte Cu-Barrierenschicht eine Schicht ist, welche Ta oder eine Verbindung desselben aufweist.

16. Verfahren gemäß irgendeinem der Ansprüche 12 bis 15, bei welchem die besagte Reaktion durch ein Erwärmen des besagten Substrats angeregt wird.

17. Verfahren gemäß Anspruch 16, bei welchem das besagte Erwärmen bei einer Temperatur in dem Bereich zwischen 50 Grad C und 400 Grad C durchgeführt wird.

## Revendications

1. Structure de métallisation comprenant:
- un motif conducteur (8);
- un diélectrique contenant du fluor (5); et
- une couche barrière de diffusion du fluor conductrice (4) comprenant au moins une première partie, qui est positionnée entre ledit diélectrique contenant du fluor et ledit motif conducteur, ladite première partie étant constituée d'une première sous-couche faite d'un matériau conducteur et d'une deuxième sous-couche faite d'un fluorure dudit matériau conducteur et qui est adjacente audit diélectrique contenant du fluor, ledit matériau conducteur étant choisi dans le groupe constitué de Co, Ni, Pt et Pd.

2. Structure selon la revendication 1, dans laquelle ladite couche barrière conductrice encapsule complètement ledit diélectrique contenant du fluor.

3. Structure selon la revendication 1, dans laquelle ladite couche barrière conductrice encapsule complètement ledit motif conducteur.

4. Structure selon l'une quelconque des revendications 1 à 3, dans laquelle ledit motif conducteur est composé d'au moins un métal choisi dans le groupe constitué de Al, de Cu, d'un alliage de Al et d'un alliage de Cu.

5. Structure selon l'une quelconque des revendications 1 à 4, dans laquelle ledit diélectrique contenant du fluor comprend au moins une ouverture.

6. Structure selon la revendication 5, dans laquelle ladite ouverture est un trou d'interconnexion ou un sillon.

7. Structure selon l'une quelconque des revendications 1 à 6, dans laquelle ledit motif conducteur est composé de Cu ou d'un alliage de Cu.

8. Structure selon la revendication 7, comprenant en outre une couche barrière de Cu, qui est imperméable au cuivre et positionnée entre ledit motif conducteur et ladite couche barrière conductrice.

9. Structure selon la revendication 8, dans laquelle ladite couche barrière de Cu est une couche de Ta ou un composé de celui-ci.

10. Structure selon l'une quelconque des revendications 1 à 9, dans laquelle ladite couche barrière conductrice comprend en outre une deuxième partie, qui est positionnée entre une couche de silicium et ledit motif conducteur, ladite deuxième partie étant constituée d'une troisième sous-couche dudit matériau conducteur et d'une quatrième sous-couche d'un siliciure dudit matériau conducteur, ladite quatrième sous-couche étant en contact avec ladite couche de silicium.

11. Structure selon la revendication 10, dans laquelle ladite couche de silicium est au moins une partie d'une rondelle de silicium.

12. Procédé pour la fabrication d'une structure de métallisation selon l'une quelconque des revendications 1 à 11 sur un substrat comprenant les étapes consistant:
- à déposer une couche d'un matériau conducteur qui est choisi dans le groupe constitué de Co, Ni, Pt et Pd sur au moins une surface exposée d'un diélectrique contenant du fluor formé sur ledit substrat;
- à permettre la réaction entre ladite couche dudit matériau conducteur et ledit diélectrique contenant du fluor pour former ainsi une couche d'un fluorure dudit matériau conducteur à l'interface entre ladite couche dudit matériau conducteur et ledit diélectrique contenant du fluor dans le but de créer la couche barrière de diffusion du fluor conductrice; et
- à déposer au moins un métal sur ladite couche dudit matériau conducteur dans le but de créer le motif conducteur.

13. Procédé selon la revendication 12, dans lequel ledit métal est choisi dans le groupe constitué de Al, de Cu, d'un alliage de Al et d'un alliage de Cu.

14. Procédé selon l'une quelconque des revendications 12 à 13, dans lequel, avant le dépôt dudit métal, une couche barrière de Cu est formée au moins sur ladite couche dudit matériau conducteur.

15. Procédé selon la revendication 14, dans lequel ladite couche barrière de Cu est une couche comprenant Ta ou un composé de celui-ci.

16. Procédé selon l'une quelconque des revendications 12 à 15, dans lequel ladite réaction est stimulée en chauffant ledit substrat.

17. Procédé selon la revendication 16, dans lequel ledit chauffage est effectué à une température dans l'intervalle de 50 degrés C à 400 degrés C.
